# EUROPÄISCHE PATENTSCHRIFT

(11) **EP 2 441 546 B1**
(45) Veröffentlichungstag und Bekanntmachung des Hinweises auf die Patenterteilung: **24.04.2013**
(21) Anmeldenummer: 10013564.9
(22) Anmeldetag: 12.10.2010
(51) Int. Cl.: B23K 26/06, B23K 26/073, H01L 31/0224, H01L 21/268

(54) **Verfahren und Vorrichtung zum Dotieren ausgewählter Bereiche einer Solarzelle**
Method and apparatus to form selective emitter areas on a solar cell
Méthode et dispositif pour doper de manière sélective la surface d'une cellule solaire

(43) Veröffentlichungstag der Anmeldung: 18.04.2012
(73) Patentinhaber: Innovavent GmbH, 37085 Göttingen (DE); JENOPTIK Optical Systems GmbH, 07745 Jena (DE)
(72) Erfinder: Gnausch, Tobias, 99974 Mühlhausen (DE); Oesterlin, Peter, 37077 göttingen (DE)
(74) Vertreter: von Hellfeld, Axel

(56) Entgegenhaltungen:
- JP-A- 4 282 869
- JP-A- 5 315 278
- KR-A- 20090 091 474
- US-A1- 2004 040 938
- RODER T ET AL: "0.4% absolute efficiency gain of industrial solar cells by laser doped selective emitter", PHOTOVOLTAIC SPECIALISTS CONFERENCE (PVSC), 2009 34TH IEEE, IEEE, PISCATAWAY, NJ, USA, 7. Juni 2009 (2009-06-07), Seiten 871-873, XP031626438, ISBN: 978-1-4244-2949-3

## Beschreibung

Die Erfindung betrifft ein Verfahren und eine Vorrichtung zum Dotieren ausgewählter Bereiche einer Solarzelle mittels Bestrahlung dieser ausgewählten Bereiche mit Laserstrahlung.

Kristalline Solarzellen werden üblicherweise auf sog. Siliziumwafern hergestellt. Solche Wafer haben zur Zeit typischerweise eine Stärke im Bereich von 150 bis 200 µm. In Zukunft sind auch geringere Stärken denkbar. Die Wafer haben zur Zeit typischerweise Abmessungen von 125 mm x 125 mm oder auch 156 mm x 156 mm.

Der Stand der Technik kennt unterschiedliche Verfahren zur Herstellung kristalliner Solarzellen. Ein weit verbreitetes Verfahren sieht zur Herstellung einer kristallinen Solarzelle folgende Schritte vor:
1. Auf einem bereitgestellten Siliziumwafer wird eine sog. Oberflächentextur hergestellt, typischerweise in Form einer Vielzahl von die Oberfläche abdeckenden Pyramiden, um die Absorption von Sonnenlicht zu fördern.
2. Ein Stoff, der einen Donator enthält, wird auf die Oberfläche aufgebracht. Ein typischer Donator ist Phosphor, jedoch sind auch andere Elemente aus der dritten oder fünften Hauptgruppe des Periodensystems als Donatoren geeignet.
3. In einem Diffusionsofen wird der Donator in das Silizium hineindiffundiert. Die Diffusion erfolgt dabei in der festen Phase des Siliziums, also unterhalb des Schmelzpunkts des Siliziums. Der Donator, wie zum Beispiel Phosphor, diffundiert dabei in das Kristallgitter des Siliziums hinein und wird zu einem geringen Teil elektrisch aktiv indem der Donator Siliziumatome im Kristallgitter ersetzt. Die Aktivierungsrate liegt dabei normalerweise unter 10%. So entsteht ein schwach dotierter pn-Übergang an der Oberfläche der Solarzelle. Dieser pn-Übergang sorgt für die Trennung der Ladungsträger, die durch die Photonen des Sonnenlichts im Silizium erzeugt werden. Bei dem Diffusionsprozess entsteht auch ein Phosphorsilikatglas (PSG) auf der Oberfläche. Dabei handelt es sich um eine Siliziumoxidschicht, die geringe Mengen an Phosphor enthält.
4. Die Schicht aus Phosphorsilikatglas (PSG) wird mit einem Ätzprozess (zum Beispiel Flusssäure HF) entfernt.
5. Es wird eine Antireflexschicht aufgebracht, um die Absorption von Sonnenlicht weiter zu fördern. Die Antireflexschicht besteht häufig aus SiN.
6. Es werden sog. Kontaktfinger auf die so erzeugte Oberfläche aufgebracht, wobei die genannte Antireflexschicht durchbrochen wird. Die Kontaktfinger sind schmale Metallstreifen, die sich parallel jeweils in gerader Linie über die Solarzellen erstrecken, um die erzeugte elektrische Spannung abzugreifen. Eine Solarzelle hat typischerweise heutzutage zwischen 60 und 150 derartige Kontaktfinger, die jeweils eine Breite von typischerweise 20 bis 300 µm haben.

Bei der Herstellung von Solarzellen gibt es eine Vielzahl von Varianten des vorstehend beschriebenen Verfahrens. Die Ergebnisse sind aber ähnlich: im Wesentlichen geht es um die Erzeugung eines pn-Übergangs, das Aufbringen von Oberflächenstrukturen und Schichten zur Verringerung der Reflexion und zur Förderung der Absorption von Sonnenlicht, und das Aufbringen von Kontakten zur Ableitung des elektrischen Stroms. Die vorliegende Erfindung greift insbesondere auf das oben beschriebene Verfahren (Ziffern 1 bis 6) zurück, ist aber nicht darauf beschränkt.

Die genannten elektrischen Kontaktstreifen, üblicherweise als Kontaktfinger bezeichnet, stehen in elektrischem Kontakt mit der Oberfläche des pn-Übergangs der Solarzelle. Das Herstellungsverfahren für die Solarzelle, wie oben skizziert, erzeugt aber einen nur schwach dotierten Übergang, so dass der elektrische Widerstand zum Kontaktfinger relativ hoch ist. Der typische Oberflächen-Schichtwiderstand liegt im Bereich von 100 Ohm/Square. Durch diesen relativ hohen elektrischen Widerstand entstehen beim Ableiten des elektrischen Stroms ohmsche Verluste und dadurch wird der Wirkungsgrad einer Solarzelle verringert.

Grundsätzlich wäre es denkbar, den pn-Übergang stärker zu dotieren oder auch die oben erwähnte Aktivierungsrate des Donators vom oben genannten typischen Wert kleiner 10% auf einen Wert größer als 50% anzuheben. Dadurch aber würde die Rekombinationsrate der Ladungsträger, die durch das Sonnenlicht erzeugt werden, größer, so dass weniger Ladungsträger abgezogen werden könnten, wodurch dann der Wirkungsgrad der Solarzelle reduziert würde.

Deshalb kennt der Stand der Technik bereits das sog. selektive Dotieren von Solarzellen. Dabei erhöht man die Konzentration der Dotierung nur an den Orten, an denen später die Kontaktfinger (Metallkontakte) positioniert werden. Dadurch wird der ohmsche Widerstand an den Kontaktfingern reduziert, ohne in den Bereichen, in denen das Sonnenlicht absorbiert und in Ladungsträger umgewandelt wird, die Rekombinationsrate der Ladungsträger zu erhöhen. Es werden also die ohmschen Verluste beim Abgreifen des Stroms verringert, ohne andere Eigenschaften der Solarzelle zu verschlechtern. Das Ergebnis dieses selektiven Dotierens wird in der Fachsprache auch mit "selective emitter" bezeichnet, vgl. WO 2009/013307 A2.

Zur Durchführung dieser selektiven Dotierung, also der Erzeugung des selektiven Emitters, eignen sich ganz besonders Laser, da Laserstrahlung auf eine Fleckgröße (Abmessungen des sog. Spots) fokussiert werden kann, die im Bereich der Breite der genannten Kontaktfinger liegt, also im Bereich von typischerweise 20 bis 300 µm. Der Prozess der Erzeugung selektiver Emitter mittels Laser wird zum Beispiel beschrieben in der Veröffentlichung "0.4% ABSOLUTE EFFICIENCY GAIN OF INDUSTRIAL SOLAR CELLS BY LASER DOPED SELECTIVE EMITTER" von T. Röder in "IEEE, 2009, S. 1005-1007" vgl. auch "Proceedings of the 34th IEEE Photovoltaic Specialists Conference, Philadelphia, USA". Dementsprechend kann nach dem obigen Schritt Nr. 3 (also der Diffusion) ein auf die Breite der aufzubringenden Kontaktfinger fokussierter Laserspot über den Wafer bewegt werden. Überall dort, wo dieser Laserspot die Siliziumoberfläche hinreichend aufheizt, diffundiert zusätzlich Phosphor (oder ein anderer Donator) in das Silizium hinein und wird zu einem hohen Prozentsatz (bis zu 80%) elektrisch aktiviert. Dadurch sinkt der Schichtwiderstand von den oben genannten etwa 100 Ohm/Square auf etwa 20 Ohm/Square und somit wird der elektrische Widerstand zu den anschließend aufgebrachten Kontaktfingern erheblich reduziert. Es kann geschätzt werden, dass dadurch der Wirkungsgrad (die Effizienz) der Solarzelle von zum Beispiel 17% auf 17,3 bis 17,4 % ansteigt.

Die US 2004/0040938 A1 beschreibt eine Anlage zur Erzeugung eines homogenen Linienstrahls und deren Anwendung zur Kristallisation dünner Siliziumschichten. Dabei werden mehrere Laser eingesetzt und deren emittierte Strahlung wird zur teilweisen Überlappung gebracht. Da Licht verschiedener Laser (auch bei gleicher Bauart) zueinander inkohärent ist, kommt es dabei nicht zu Interferenzeffekten.

Solarzellen werden in hohen Stückzahlen in Produktionsstrassen hergestellt. Typische Taktraten derartiger Produktionsstrassen sind etwa 1 Sekunde pro Zelle. Wenn in dieser kurzen Zeit bis zu 150 Bereich auf der Solarzelle, in denen später die Kontaktfinger erzeugt werden, mit einem Laserstrahl abgefahren werden sollen, dann ist nachvollziehbar, dass mehr als ein Laserspot eingesetzt werden muss. Es muss eine sehr große Anzahl von derartigen Bereichen parallel, also gleichzeitig bearbeitet werden.

Dazu geeignet sind sog. Strahlteiler, die einen Laserstrahl in eine Vielzahl (zum Beispiel bis zu 150) Teilstrahlen mit jeweils identischen Eigenschaften zerlegen. Wenn die zu bearbeitenden Bereiche auf der herzustellenden Solarzelle für jeden einzelnen später aufzubringenden Kontaktfinger eine Breite von zum Beispiel 50 µm oder mehr aufweisen, dann ist es anzustreben, dass das sog. Intensitätsprofil jedes einzelnen Spots zumindest annähernd rechteckförmig ist, also ein Profil hat, das in der Fachsprache mit "Top Hat" bezeichnet wird. Dadurch erfolgt die Dotierung homogen über die gesamte Breite des zu bearbeitenden Bereiches und damit wird dann auch der Kontaktwiderstand zum Kontaktfinger entsprechend gering über die gesamte Breite des Kontaktfingers.

Eine Möglichkeit zur Erzeugung homogener Intensitätsprofile ist die Verwendung eines diffraktiven Strahlformers. Dieser ist genau auf die einfallende Lichtverteilung abgestimmt und verteilt das Licht in der Targetebene um. D.h. die Gauß-förmige Laserstrahlung wird so lange gestaucht und gestreckt, bis sich die gewünschte Top Hat-Verteilung ergibt. Voraussetzung ist, dass die Eingangslichtverteilung sehr genau bekannt ist und sich auch nicht während des Prozesses verändert. Letzteres würde dazu führen, dass der Top Hat nicht mehr homogen ist. Sein Uniformitätsfehler würde drastisch ansteigen.

Eine andere Möglichkeit, die nicht die genaue Kenntnis und die zeitliche Invarianz der Eingangslichtverteilung erfordert, ist die Verwendung eines Strahlteilers, der den Strahl in mehrere einzelne Strahlen aufteilt, die sich so überlappen, dass die Gesamtintensität ein Top Hat-Profil ergibt. Damit erhält man einen Diffuser. Diese Überlappung der Einzelspots führt bei der Verwendung von kohärentem Licht zu Speckle (Intensitätsmodulation bis zu 100 %) aufgrund der phasenrichtigen Superposition der einzelnen Beugungsordnungen (Spots). Bei der Verwendung von partiell kohärentem Licht, wie es das Licht eines Multimodelasers darstellt, in Verbindung mit einem Diffuser werden die Speckle bzw. der Specklekontrast, also die Intensitätsmodulationen geringer, sind aber immer noch präsent und werden den Bearbeitungsprozess stören.

Die vorliegende Erfindung setzt an dieser Stelle an und hat die Aufgabe, ein Verfahren und eine Vorrichtung zum Dotieren von ausgewählten Bereichen einer Solarzelle bereitzustellen, mit denen eine effektive und homogene Dotierung in den ausgewählten Bereichen erreicht wird.

Durch die Bestrahlung der Solarzelle während der Relativbewegung zwischen Strahlung und Solarzelle entstehen langgestreckte, bandförmige bestrahlte Teilbereiche der Solarzelle und diese Teilbereiche überlappen sich so entlang ihrer Ränder, dass insgesamt in dem bestrahlten Bereich der Solarzelle, der eine Kontaktfingerbahn ergibt, eine im Wesentlichen homogene Bestrahlung, ohne Kohärenzeffekte, erreicht wird und somit auch eine homogene erhöhte Dotierung im Bereich der Kontaktfingerbahn.

Vorteilhafte Ausgestaltungen des Verfahrens bzw. der Vorrichtung sind in den abhängigen Ansprüchen beschrieben.

Nachfolgend wird ein Ausführungsbeispiel der Erfindung anhand der Zeichnung näher erläutert. Es zeigt:
- Fig. 1: schematisch zunächst eine Vorrichtung zum Dotieren von ausgewählten Bereichen bei der Herstellung einer Solarzelle zur Erläuterung der Erfindung, ohne die erfindungsgemäßen Merkmale;
- Fig. 2: schematisch eine erfindungsgemäße Vorrichtung zum Dotieren ausgewählter Bereiche bei der Herstellung einer Solarzelle und
- Fig. 3: ein Detail der Vorrichtung gemäß Fig. 2 in vergrößerter Darstellung.

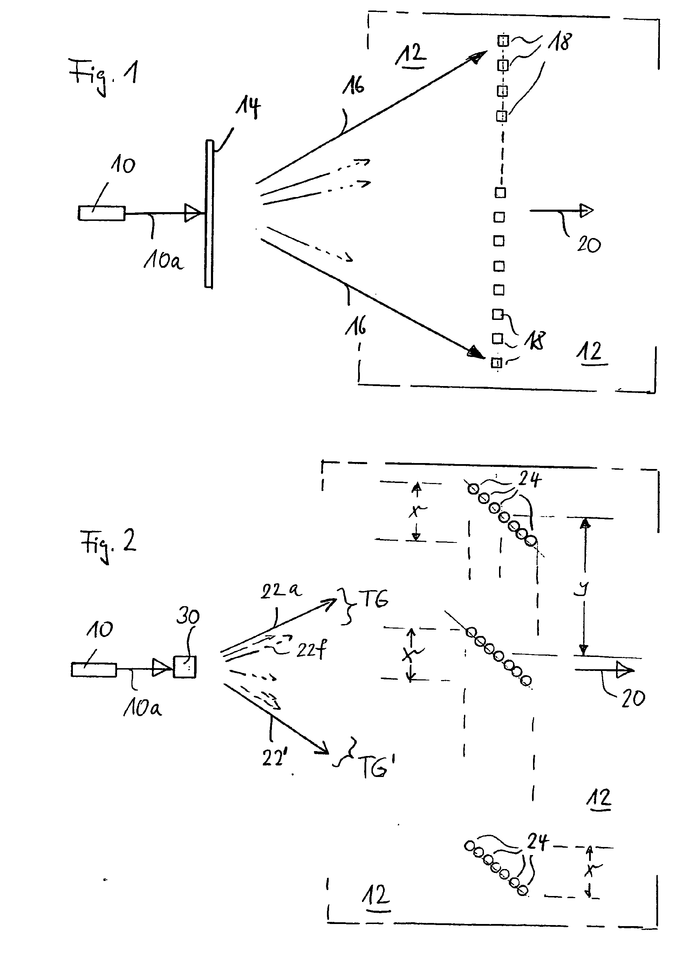

Fig. 1 zeigt einen Laser 10, der einen gepulsten Laserstrahl 10a emittiert. Ein diffraktives optisches Element (DOE) 14 zerlegt den Laserstrahl in eine Vielzahl von Teilstrahlen 16, die jeweils entsprechend der Anzahl von ausgewählten Bereichen, auf die Kontaktfinger aufgebracht werden sollen, einzelne sog. Laserspots 18 erzeugen. Die Solarzelle 12 bewegt sich in Richtung des Pfeils 20, so dass Dotierungsbahnen für die Kontaktfinger in der Figur von rechts nach links erzeugt werden. Die Laserstrahlungsquelle 10 und das DOE liegen in Wirklichkeit über der Zeichnungsebene, also senkrecht auf der Oberfläche der Solarzelle, die in der Zeichnungsebene liegt. Zur vereinfachten Darstellung sind der Laser 10 und das DOE aber in Fig. 1 (so auch in Fig. 2) um 90° nach links gekippt.

Wird mit einer Anordnung gemäß Fig. 1 und mit einem die Strahlteilung und die Homogenisierung in den Teilstrahlen 16 erzeugenden diffraktiven optischen Element (DOE) gearbeitet, dann ergeben sich bei Verwendung kohärenter Laserstrahlung Probleme. Die Kohärenz bewirkt nämlich eine unerwünschte Strukturierung (Inhomogenität) in der erzeugten Intensitätsverteilung in jedem einzelnen Spot 18 und somit eine ungleichmäßige Dotierung im Wafer.

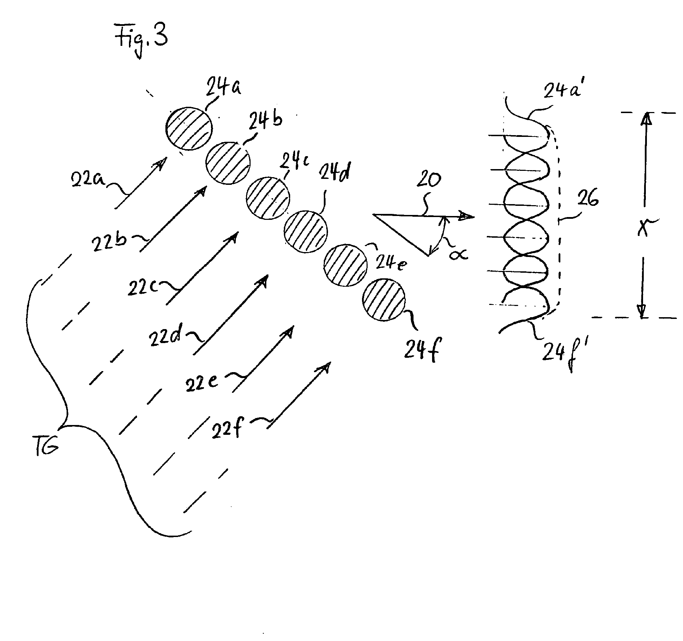

Deshalb geht die Erfindung einen anderen Weg, der in den Fig. 2 und 3 illustriert ist. Ein Strahlteiler 30, für den insbesondere ein DOE eingesetzt werden kann, ist nicht für eine Homogenisierung durch Überlappung von Teilstrahlen ausgelegt, sondern zerlegt den eingehenden Laserstrahl 10a in eine Vielzahl von Teilstrahlen in Form von Teilstrahlungsgruppen TG bis TG'. Die Anzahl dieser Teilstrahlungsgruppen TG bis TG' entspricht der Anzahl der Bereiche, auf denen Kontaktfinger angebracht werden sollen. Wie oben ausgeführt ist, sind zur Zeit etwa 60 bis 150 Kontaktfinger typisch, wobei jeder Bereich auf der Solarzelle, dem jeweils eine Teilstrahlungsgruppe TG zugeordnet ist, die oben genannte Breite von typischerweise 50 bis 300 µm hat. Der Einfachheit halber sind in den Figuren nur jeweils ganz wenige solcher Bereiche auf der Solarzelle 12 eingezeichnet und auch die Anzahl der jeweils zugeordneten Teilstrahlungsgruppen ist mit stark verringerter Anzahl dargestellt.

Der auf den Strahlteiler 30 auftreffende Laserstrahl 10a hat bei einer Vielzahl von Lasertypen kein top-hat-Profil, sondern typischerweise eine Gauß-Verteilung der Intensität, die üblicherweise auch mit Glockenform bezeichnet wird. Erfindungsgemäß wird diese Gauß-förmige Intensitätsverteilung in den vom Strahlteiler 30 erzeugten Teilstrahlen 22a bis 22f nicht homogenisiert und so auf die Oberfläche des Wafers gerichtet, dass sich die Teilstrahlen 22a bis 22f einander nicht überschneiden. In Fig. 2 sind die Bereiche, in denen die Dotierung, wie oben beschrieben, zu erhöhen ist, mit "x" bezeichnet (nur drei Bereiche dargestellt, tatsächlich sind es typischerweise bis zu 150 Bereiche oder mehr).

Durch den Strahlteiler 30 werden eine entsprechende Vielzahl von Teilstrahlungsgruppen TG erzeugt, die beim dargestellten Ausführungsbeispiel aus jeweils sechs Teilstrahlen 22a, 22b, 22c, 22d, 22e, 22f bestehen, welche bei der Bestrahlung der Solarzelle 12 einander nicht überschneiden. Jeder einzelne dieser Teilstrahlen erzeugt im zu bestrahlenden Bereich x jeweils einen bestrahlten Teilbereich bzw. Laserspot 24a, 24b, 24c, 24d, 24e, 24f. Die relative Bewegungsrichtung zwischen den Spots und dem Wafer ist wieder mit dem Pfeil 20 gekennzeichnet.

Fig. 3 zeigt eine einzelne Teilstrahlungsgruppe TG in vergrößertem Maßstab mit den einzelnen Teilstrahlen 22a bis 22f und den hierdurch jeweils erzeugten bestrahlten Teilbereichen bzw. Laserspots 24a bis 24f. Fig. 3 zeigt auch die jeweils vorliegende Intensitätsverteilung in jedem einzelnen Teilbereich bzw. Spot, nämlich die Gauß-Verteilungen 24a' bis 24f. Bei Relativbewegung zwischen der Solarzelle 12 und den Laserspots 18 gemäß dem Pfeil 20 entstehen streifenförmige, parallel zueinander verlaufende Dotierungsbereiche in der Solarzelle und diese streifenförmigen Dotierungsbereiche überlappen einander an ihren Rändern, so wie es die vorstehend genannten Gauß-Verteilungen darstellen. Insgesamt entsteht ein weitgehend homogenes Dotierungsergebnis (Fig. 3, 26).

Wie Fig. 3, rechts, zeigt, überlappen die Dotierungsverteilungen in den einzelnen bestrahlten Teilbereichen 24a bis 24f bei Relativbewegung zwischen Strahlung und Solarzelle 12 (Pfeil 20) einander nicht vollständig, sondern nur teilweise. Die Überlappung der Dotierungen in den Teilbereichen ist beim Ausführungsbeispiel so, dass ihre Maxima einander nicht überlappen. Bevorzugt ist die Überlappung der Dotierungen in den einzelnen Teilbereichen so, dass sich die Dotierungsverteilungen zumindest angenähert an der Stelle der Halbwertsbreiten (FWHM) schneiden, wie Fig. 3 beispielhaft zeigt. Auf diese Weise überlappen sich die Dotierungen in den Teilbereichen derart, dass sie sich zu einer Gesamt-Dotierungsverteilung addieren, die eine maximal mögliche Homogenität aufweist, d.h. eine gleichförmige Dotierungsverteilung, abgesehen von den beiden äußeren Rändern, ohne dass Kohärenzeffekte stören.

Die Anzahl der eingesetzten Teilstrahlen 22a bis 22f bzw. der damit bestrahlten Teilbereiche bzw. Laserspots 24a bis 24f kann gegenüber der in den Fig. 2 und 3 dargestellten Anzahl variieren, je nach eingesetztem Laser, verwendetem Strahlteiler, verschiedenen optischen Komponenten und auch den jeweils erwünschten Strahlungsleistungen auf den zu bestrahlenden Flächen. So kann die Anzahl der Teilstrahlen in einer Teilstrahlungsgruppe bzw. der damit bestrahlten Teilbereiche bzw. Laserspots von zum Beispiel 2 bis 12 oder mehr variieren.

Wie die Fig. 2 und 3 zeigen, sind die Teilstrahlen einer Teilstrahlungsgruppe TG auf einer Linie angeordnet, die einen Winkel α mit der relativen Bewegungsrichtung 20 zwischen Strahlung und Wafer bildet. Dieser Winkel kann je nach den verwendeten optischen Komponenten und anderen Anforderungen variieren, zum Beispiel im Bereich von 5 bis 15 Grad.

## Patentansprüche

1. Verfahren zum Dotieren von ausgewählten Bereichen (x) einer Solarzelle (12) mittels Bestrahlung der ausgewählten Bereiche (x), auf die eine einen Donator enthaltende Substanz aufgebracht ist, mit Laserstrahlung, **dadurch gekennzeichnet, dass** die Laserstrahlung, mit der die ausgewählten Bereiche (x) bestrahlt werden, mit einem Laser (10) erzeugt wird, dessen emittierte Strahlung (10a) in eine Vielzahl von Teilstrahlen (16) zerlegt wird, welche sich im Wesentlichen nicht direkt überlappen, wobei sich die von benachbarten Teilstrahlen (22a, 22b, 22c, 22d, 22e, 22f; 22') bestrahlten Teilbereiche (24, 24a, 24b, 24c, 24d, 24e, 24f) eines ausgewählten Bereichs (x) der Solarzelle (12) einander aufgrund einer Relativbewegung zwischen Strahlung und Solarzelle (12) derart überlappen, dass ein homogenes Dotierungsergebnis entsteht.

2. Verfahren nach Anspruch 1, **dadurch gekennzeichnet, dass** die Teilstrahlen (22a, 22b, 22c, 22d, 22e, 22f; 22') jeweils eine inhomogene Intensitätsverteilung, insbesondere eine Gauß-Verteilung haben.

3. Verfahren nach einem der Ansprüche 1 oder 2, **dadurch gekennzeichnet, dass** die Teilstrahlen (22a, 22b, 22c, 22d, 22e, 22f; 22') simultan und in einer festen räumlichen Relation zueinander relativ zur Solarzelle (12) bewegt werden.

4. Verfahren nach einem der vorhergehenden Ansprüche, **dadurch gekennzeichnet, dass** die Teilstrahlen (22a, 22b, 22c, 22d, 22e, 22f; 22'), mit denen ein ausgewählter Bereich (x) bestrahlt wird, einander unmittelbar benachbart auf die Solarzelle (12) treffen.

5. Verfahren nach einem der vorhergehenden Ansprüche, **dadurch gekennzeichnet, dass** die ausgewählten Bereiche (x) Kontaktfingerbahnen der Solarzelle (12) sind.

6. Verfahren nach einem der vorhergehenden Ansprüche, **dadurch gekennzeichnet, dass** die Überlappung der bestrahlten Teilbereiche (24; 24a, 24b, 24c, 24d, 24e, 24f) so ist, dass die Dotierung im jeweils ausgewählten Bereich (x) im Wesentlichen homogen ist.

7. Verfahren nach einem der vorhergehenden Ansprüche, **dadurch gekennzeichnet, dass** die Teilstrahlen (22a, 22b, 22c, 22d, 22e, 22f; 22') mit zumindest einem diffraktiven optischen Element (30) erzeugt werden.

8. Verfahren nach einem der vorhergehenden Ansprüche, **dadurch gekennzeichnet, dass** mehrere Sätze (TG; TG') von Teilstrahlen aus einem Laserstrahl (10a) erzeugt und simultan auf die Solarzelle (12) gerichtet werden, wobei jeder Satz von Teilstrahlen mehrere Teilstrahlen (22a, 22b, 22c, 22d, 22e, 22f; 22') enthält.

## Claims

1. A method of doping selected areas (x) of a solar cell (12) by irradiating with laser radiation the selected areas (x) having applied thereto a substance containing a donor, **characterized in that** the laser radiation with which the selected areas (x) are irradiated is generated by means of a laser (10) whose emitted radiation (10a) is split into a plurality of partial beams (16) which substantially do not directly overlap one another, wherein, due to a relative movement between the radiation and the solar cell (12), the subareas (24, 24a, 24b, 24c, 24d, 24e, 24f) of a selected area (x) of the solar cell (12) which are irradiated by adjacent partial beams (22a, 22b, 22c, 22d, 22e, 22f; 22') overlap each other such that homogeneous doping is attained.

2. The method according to claim 1, **characterized in that** each of the partial beams (22a, 22b, 22c, 22d, 22e, 22f; 22') has an inhomogeneous distribution, especially a Gaussian distribution.

3. The method according to one of the claims 1 or 2, **characterized in that** the partial beams (22a, 22b, 22c, 22d, 22e, 22f; 22') are moved relative to the solar cell (12) simultaneously and in a fixed spatial relation relative to one another.

4. The method according to one of the preceding claims, **characterized in that** the partial beams (22a, 22b, 22c, 22d, 22e, 22f; 22') with which a selected area (x) is irradiated impinge on the solar cell (12) directly adjacent one another.

5. The method according to one of the preceding claims, **characterized in that** the selected areas (x) are contact finger paths of the solar cell (12).

6. The method according to one of the preceding claims, **characterized in that** the irradiated subareas (24; 24a, 24b, 24c, 24d, 24e, 24f) overlap in such a way that the doping in the respective selected area (x) is substantially homogeneous.

7. The method according to one of the preceding claims, **characterized in that** the partial beams (22a, 22b, 22c, 22d, 22e, 22f; 22') are produced by at least one diffractive optical element (30).

8. The method according to one of the preceding claims, **characterized in that** a plurality of sets (TG; TG') of partial beams is produced from a laser beam (10a) and directed simultaneously onto the solar cell (12), each set of partial beams including a plurality of partial beams (22a, 22b, 22c, 22d, 22e, 22f; 22').

## Revendications

1. Procédé pour doper des zones sélectionnées (x) d'une cellule solaire (12) par irradiation par rayonnement laser desdites zones sélectionnées (x) sur lesquelles est appliquée une substance contenant un donneur, **caractérisé en ce que** le rayonnement laser servant à irradier les zones sélectionnées (x) est produit par un laser (10) dont le rayonnement émis (10a) est décomposé en une multitude de rayons partiels (16) lesquels ne se chevauchent pour l'essentiel pas directement, les zones partielles (24, 24a, 24b, 24c, 24d, 24e, 24f) d'une zone sélectionnée (x) de ladite cellule solaire (12) irradiées par les faisceaux partiels voisins (22a, 22b, 22c, 22d, 22e, 22f ; 22') se chevauchant les unes les autres en raison d'un mouvement relatif entre le rayonnement et la cellule solaire (12) de telle sorte qu'on obtient un résultat de dopage homogène.

2. Procédé selon la revendication 1, **caractérisé en ce que** lesdits faisceaux partiels (22a, 22b, 22c, 22d, 22e, 22f ; 22') possèdent chacun une distribution d'intensité non homogène, en particulier une distribution de Gauss.

3. Procédé selon l'une des revendications 1 ou 2, **caractérisé en ce que** les faisceaux partiels (22a, 22b, 22c, 22d, 22e, 22f ; 22') sont mus simultanément les uns par rapport aux autres, selon une relation spatiale déterminée par rapport à la cellule solaire (12).

4. Procédé selon l'une des revendications précédentes, **caractérisé en ce que** les faisceaux partiels (22a, 22b, 22c, 22d, 22e, 22f ; 22') avec lesquels une zone sélectionnée (x) est irradiée tombent directement voisins les uns des autres sur la cellule solaire (12).

5. Procédé selon l'une des revendications précédentes, **caractérisé en ce que** les zones sélectionnées (x) consistent en des voies de doigt de contact de la cellule solaire (12).

6. Procédé selon l'une des revendications précédentes, **caractérisé en ce que** le chevauchement des zones partielles irradiées (24, 24a, 24b, 24c, 24d, 24e, 24f) est pour l'essentiel homogène dans la zone sélectionnée (x).

7. Procédé selon l'une des revendications précédentes, **caractérisé en ce que** les faisceaux partiels (22a, 22b, 22c, 22d, 22e, 22f ; 22') sont produits pour le moins par un élément optique diffractif (30).

8. Procédé selon l'une des revendications précédentes, **caractérisé en ce que** plusieurs jeux (TG ; TG') de faisceaux partiels sont produits à partir d'un rayon laser (10a) et dirigés simultanés sur la cellule solaire (12), chacun des jeux de faisceaux partiels comportant plusieurs faisceaux partiels (22a, 22b, 22c, 22d, 22e, 22f ; 22').
